# EUROPEAN PATENT APPLICATION

(11) **EP 1 993 124 A1**
(43) Date of publication of application: **19.11.2008**
(21) Application number: 07715235.3
(22) Date of filing: 06.03.2007
(51) Int. Cl.: H01L 21/60, H05K 3/32

(54) **MOUNTING METHOD, BOARD WITH ELECTRICAL COMPONENT, AND ELECTRICAL APPARATUS**

(30) Priority: 07.03.2006 JP 2006060600
(71) Applicant: Sony Chemical & Information Device Corporation, Tokyo 141-0032 (JP)
(72) Inventor: FURUTA, Kazutaka, Kanuma-shi, Tochigi 322-8503 (JP); KANISAWA, Shiyuki, Kanuma-shi, Tochigi 322-8503 (JP); TANIGUCHI, Masaki, Kanuma-shi, Tochigi 322-8503 (JP)
(74) Representative: Körber, Martin Hans
(86) International application number: PCT/JP2007/054267
(87) International publication number: WO 2007/102482

(57) **Abstract**

An electric device having high reliability is to be produced. An adhesive layer 20 includes a thermosetting resin and a radiation-curable resin, and a portion of the adhesive layer 20 is protruded outwardly from an edge of the electric part 15. Radiation rays 29 do not pass through the electric part 15, and the radiation-curable resin is cured in the protruding portion 26, while the radiation-curable resin in that portion of the adhesive layer 20 which is positioned right behind the electric part 15 is not polymerized. Since the electric part 15 is fixed with the polymerized radiation-curable type resin, the electric part 15 is not misaligned when the electric part 15 is pressed under heating.

## Description

### Technical Field

The present disclosure generally relates to a mounting method for mounting an electric part on a substrate.

### Background Art

Conventionally, as known in the art, adhesives have been used for mounting electric parts such as semiconductor elements. When using an adhesive layer to mount an electric part, the adhesive is placed between a substrate and the electric part, and the electric part is pressed by applying a push using a pressing head.

Conventionally, hard heads made of metals such as metals, ceramics or the like are often used as the pressing heads, and elastic heads having elastic bodies (pressing rubbers) such as a silicone rubber or the like are sometimes used. When the pressing is carried out by pushing the pressing rubber of the elastic head against the electric part as opposed to using a hard head, advantages result including the removal of voids from the adhesive and the reliability of connection between the electric part and the substrate is improved.

However, in the mounting methods conventionally known in the art, problems such as misalignment of the electric part is likely to occur from pressing, and such misalignment is further increased particularly when the elastic head is used.

When the adhesive contains a thermosetting resin, if the adhesive is heated to be half cured before the electric part is pressed with the elastic head, the misalignment can be prevented to some extent because the electric part is fixed with the half cured adhesive. However, even if this method is used, the electric part can still be misaligned by approximately 25µm.

Patent Document 1: JP-A 11-45904

Patent Document 2: JP-A 2000-105388

Patent Document 3: JP-A 2005-32952

### Disclosure of the Invention

### Problems to be Solved by the Invention

One aspect of the present disclosure, which has been accomplished to eliminate the above problems, is to provide a mounting method capable of mounting an electric part at a high precision.

### Countermeasures to Solve the Problems

In order to solve the problems described above, one aspect of the present disclosure relates to an electric part-mounting method comprising: using a layer of an adhesive containing a thermosetting resin and a radiation-curable resin; arranging the adhesive layer, a substrate and an electric part in such a manner that the adhesive layer is positioned between the substrate and the electric part with a part of the adhesive layer protruding outwardly from an edge of the electric part; irradiating radiation rays upon the protruding portion of the adhesive layer; and thereafter applying a pressing force to between the electric part and the substrate, while the adhesive layer is being heated, and mechanically connecting the electric part to the substrate.

Another aspect of the present disclosure is directed toward an electric part-mounted method, wherein the radiation rays have a wavelength that does not allow them to pass through the electrical part, and the radiation rays are irradiated from a face of the substrate on which the electric part is disposed as well as the protruding portion of the adhesive layer.

The present disclosure is also directed toward a mounting method, wherein the adhesive layer has a planar shape that is greater than that of the electric part and when the adhesive layer is positioned between the substrate and the electric part, the edge of the electric part is surrounded by the protruding portion of the adhesive layer.

Another aspect of the present disclosure relates to an electric part-mounted substrate in which an electric part is temporarily fixed with a layer of an adhesive, the adhesive layer containing a radiation-curable resin and a thermosetting resin. In this embodiment of the present disclosure, a part of the adhesive layer is positioned between the substrate and the electric part and the other part of the adhesive layer protrudes outwardly from an edge of the electric part. The portion of the adhesive layer protruding outwardly from the edge of the electric part contains a photopolymer that polymerizes the radiation-curable resin by irradiation with radiation rays.

The present disclosure also relates to an electric device in which an electric part is fixed to a substrate with a layer of an adhesive, wherein the adhesive layer contains a radiation-curable resin and a thermosetting resin. A part of the adhesive layer is positioned between the electric part and the substrate, and another part of the adhesive layer protrudes outwardly from an edge of the electric part. The portion of the adhesive layer protruding outwardly from the edge of the electric part contains a photopolymer in which the radiation-curable resin is polymerized by irradiation with radiation rays, and the portion of the adhesive layer positioned between the electric part and the substrate contains a thermally polymerized material in which the thermosetting resin is cured by heating.

The present disclosure is configured as described above, having an electric part-mounted substrate in which the electric part is temporarily fixed to the substrate with a portion of the adhesive layer positioned between the electric part and the substrate.

In the electric part-mounted substrate, the thermally polymerized product of the thermosetting resin is not formed, and that portion of the adhesive located just behind the electric part and the portion of the adhesive protruding outwardly from the electric part contain the thermosetting resin before the thermal polymerization.

The portion of the adhesive layer protruding outwardly from the edge contains the photopolymer of the radiation-curable resin, whereas the portion located behind the electric part contains the radiation-curable resin before the photopolymerization. Since neither the radiation-curable resin nor the thermosetting resin is polymerized at a location behind the electric part, the force of temporarily fixing the electric part to the substrate is sufficiently weak such that the electric part can be removed from the substrate.

The electric device according to the present disclosure is in a state after the electric part-mounted substrate is heated, and the thermosetting resin provided in the adhesive layer is converted to the thermally polymerized product in both the adhesive portion protruding outwardly from the edge of the electric part and the adhesive portion between the substrate and the electric part. The entire adhesive layer is cured, but the portion of the cured adhesive layer between the electric part and the substrate contains the radiation-curable resin which is not photopolymerized.

### Effects of the Invention

Since the electric part is not misaligned when the electric part is mechanically connected, an electric device having high reliability can therefore be obtained. When the electric part is mechanically connected, the radiation-curable type resin is not polymerized yet in the portion of the adhesive layer positioned behind the electric part. As distinguished from the conventional prior art case where the entire adhesive layer is half cured, terminals of the electric part can be brought into contact with a land portion of the substrate with a small pressing force.

### Brief Description of the Drawings

Figs. 1(a) to Fig. 1(d) are sectional views illustrating a mounting method of the present invention;
Fig. 2 is a sectional view illustrating an electric device;
Fig. 3(a) is a plan view illustrating the state before irradiation with radiation rays; and Fig. 3(b) is a plan view illustrating the state after the irradiation with the radiation rays;
Fig. 4 is a plan view illustrating another exemplary embodiment of the arrangement of the adhesive layer;
Fig. 5 is a sectional view illustrating another exemplary embodiment of the mounting method of the present disclosure.

### Explanation of Reference Numerals

1 --- electric device, 2 --- electric part-mounted substrate, 10 --- substrate, 15 --- electric part, 20adhesive layer, 21 --- binder, 22 --- conductive particle, 26 --- protruding portion, 29 --- radiation rays

### Best Mode for Carrying Out the Invention

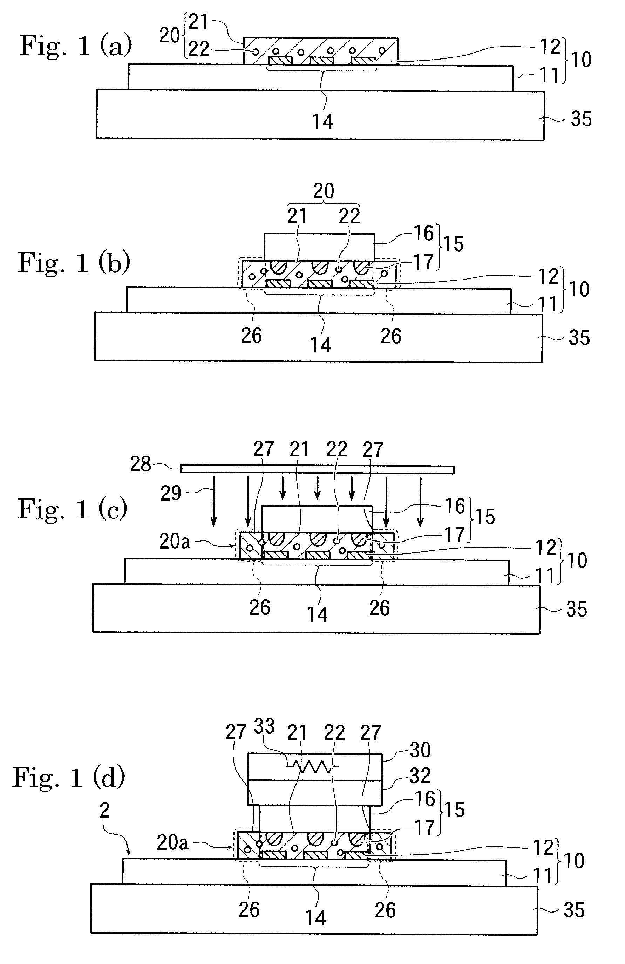

Referring to Fig. 1(a), reference numeral 10 indicates an embodiment of a substrate to be used in the present disclosure. The substrate 10 includes a substrate body 11, and lands 12 which are disposed on a front face of the substrate body 11. The front face of the substrate 10 is provided with one or more mounting areas 14 on which the electric parts, as described later, are mounted. The lands 12 are arranged on the mounting areas 14, respectively.

The substrate 10 is placed on a pressing table 35 such that the face on which the lands 12 are disposed is faced upwardly, and an adhesive layer 20, comprising a small piece of an adhesive film cut out from a whole original adhesive film sheet, is arranged on each of the mounting areas 14.

The adhesive layer 20 includes a binder 21 and conductive particles 22 dispersed in the binder 21. The binder 21 contains a thermosetting resin, a radiation-curable resin and a thermoplastic resin. When the adhesive layer 20 contains the thermoplastic resin, it has adherence property even at room temperature. When the adhesive layer 20 is lightly pressed toward the substrate 10, the adhesive layer 20 is adhered to the substrate 10.

The size of the electric part to be mounted on each of the mounting areas 14 is determined, and the size of the adhesive layer 20 attached to each of the mounting areas 14 is cut to be provided of a greater size than that of the electric part to be mounted to that mounting area 14. As a result, the layer 20 protrudes outside the periphery of the electric part when the electric part is placed on the adhesive layer 20 after the alignment as described above.

Referring to Fig. 1(b), reference numeral 15 indicates the electric part, such as a semiconductor element, for example. The electric part 15 includes a part body 16 and terminals 17 arranged on a bottom face of the part body 16.

The electric part 15 is held by a mounting head not shown, and is arranged on the corresponding mounting area 14, while the bottom face on which the terminals 17 are arranged to face in a downward direction. After the mounting head is moved such that the terminals 17 are aligned to be positioned directly above the land 12 of the corresponding mounting area 14, the mounting head is brought down to bring the electric part 15 into contact with the adhesive layer 20.

As described above, the adhesive layer 20 has an adherence property at room temperature, such that when the bottom face of the electric part 15 is brought into contact with the adhesive layer 20 by pressing the electric part 15 against the adhesive layer 20 with the mounting head or another compression bonding head, the electric part 15 is bonded and temporarily fixed to the substrate 10 with the adhesive layer 20.

In one exemplary embodiment of the present disclosure, a step of bringing the electric part 15 into contact with the adhesive layer 20 and temporarily fixing the electric part 15 to the substrate 10 is taken as a first temporarily fixing step. In this exemplary embodiment, after the first temporarily fixing step the thermosetting resin or the radiation-curable resin in the adhesive layer 20 is not polymerized, and as a result the mechanical strength of the adhesive layer 20 is weak. Thus, when the alignment is reattempted or when the electric part 15 is defective, the electric part 15 can be removed from the adhesive layer 20.

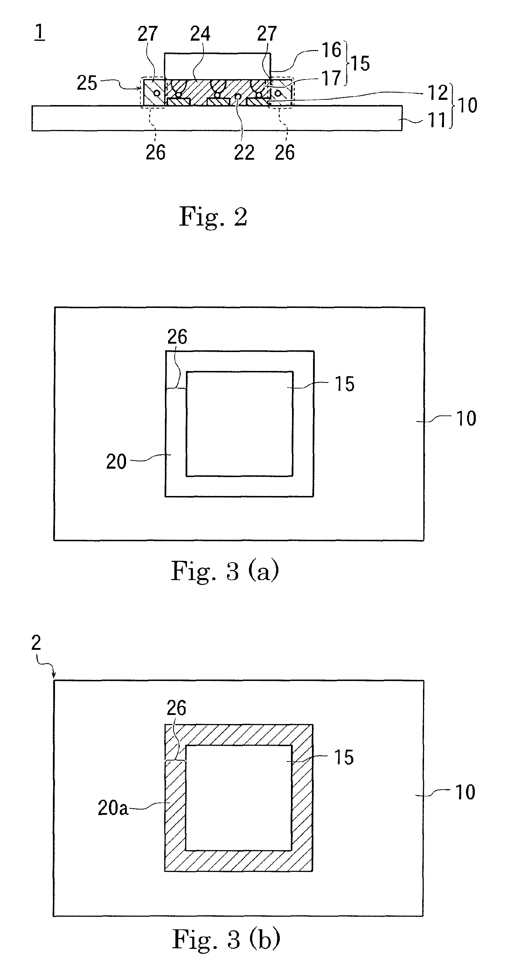

Since the adhesive layer 20 protrudes outwardly from the periphery of the electric part 15 as described above, the entire periphery of the electric part 15 is surrounded with that protruding portion 26 of the adhesive layer 20 protruding outwardly from the edge of the electric part 15 when the electric part 15 is temporarily fixed (Fig. 3(a)).

A light source 28 is arranged above the substrate 10 to which the electric part 15 is temporarily fixed. The light source 28 irradiates radiation rays 29 having such a wavelength that does not allow them to pass through the electric part 15. When the radiation rays 29 are irradiated from the light source 28 toward the face of the substrate 10 on which the electric part 15 is arranged, the radiation rays 29 are irradiated upon the protruding portion 26 (Fig. 1(c)).

Since the radiation-curable resin in the binder 21 is polymerized with the light in a predetermined wavelength range, the wavelength of the above-mentioned radiation rays 29 is incorporated in that wavelength range.

Therefore, when the radiation rays 29 are irradiated upon the protruding portion 26, a photopolymerized product is formed by photopolymerizing the radiation-curable resin. As described above, since the adhesive layer 20 is bonded to the substrate 10, and the radiation-curable resin is photopolymerized in the state where the protruding portion 26 is kept adhered to the substrate 10, the photopolymerized product of the radiation-curable resin inside the protruding portion 26 is fixed to the substrate 10 and as a result the electric part 15 is fixed to the substrate 10 by formation of the photopolymerized product in the protruding portion 26.

In another exemplary embodiment of the present disclosure, a step of producing the photopolymerized product by irradiating the radiation rays 29 to the protruding portion 26 and fixing the electric part 15 through the formation of the photopolymerized product is taken as a second temporarily fixing step. In the second temporarily fixing step, although the radiation rays 29 are irradiated to the electric part 15, the radiation rays 29 are absorbed or reflected without passing through the electric part 15. Therefore, the radiation-curable resin in that portion of the adhesive layer 20 which is positioned just behind the electric part 15 is not photopolymerized.

Referring to Fig. 1(d) and Fig. 3(b), reference numeral 2 indicates an electric part-mounted substrate after the second temporarily fixing step, and a pressing head 30 is arranged above this electric part-mounted substrate 2.

A contacting portion 32 made of a rubber or a metal is provided at one face of the pressing head 30. The pressing head 30 is brought down to bring the contacting portion 32 into contact with the electric part 15, and the electric part 15 is pressed by further descending the pressing head 30, thereby applying a pressing force between the electric part 15 and the substrate 10.

No radiation rays 29 are irradiated to the position of the adhesive layer 20a located directly behind the electric part 15, so as a result that the portion of the adhesive layer directly behind the electric part 15 does not contain a photopolymerized product of the radiation-curable resin. Therefore, the flowability of the binder 21 is maintained in the portion of the adhesive layer 20a located directly behind the electric part 15, so that the binder 21 is pushed aside by the above-mentioned pressing force.

At this time, if the binder 21 is heated, the thermoplastic resin in the binder 21 is softened to enhance the flowability, and thus the binder 21 can be pushed aside by a small pressing force.

As described above, since the photopolymer of the inner radiation-curable resin of the protruding portion 26 is fixed to the substrate 10 and the protruding portion 26 is located around the electric part 15, the electric part 15 is pressed right beneath; the electric part 15 does not become misaligned, when the binder 21 is pushed aside, even if a horizontally moving force is applied to the electric part 15 in any direction.

Since the terminals 17 are positioned directly above the lands 12, when the electric part 15 is pressed right beneath without being misaligned, the terminals 17 are brought into contact with the lands 12 directly or via the conductive particles 22. Therefore, the electric part 15 and the substrate 10 are electrically connected.

The pressing head 30 is provided with heating means 33. The contacting portion 32 is heated by the heating means 33, and the adhesive layer 20a is heated by heat conduction. When the thermosetting resin is heated beyond the curing temperature, the thermosetting resin in the binder 21, 27 is polymerized by heating to be a thermally polymerized product, and the electric part 15 and the substrate 10 are fixed in an electrically connected state.

Referring to Fig. 2, reference numeral 1 indicates an electric device in which the electric part 15 is fixed with an adhesive layer 25 formed by the thermally polymerized product. The substrate 10 and the electric part 15 are not only electrically connected, but also mechanically connected by the adhesive layer 25.

Since the thermosetting resin of the binder 24 is thermally polymerized while the adhesive layer 25 is kept adhered to the substrate 10 and the electric part 15 located at the rear face of the electric part 15, the electric part 15 and the substrate 10 are firmly connected. Therefore, it is difficult to separate the electric part 15 and the substrate 10 from the adhesive layer 25.

In addition, the thermosetting resin in the protruding portion 26 may be or may not be thermally polymerized. When the thermosetting resin is thermally polymerized at the position of the rear face of the electric part 15, the thermosetting resin may be thermally polymerized by heating the protruding portion 26 together.

The foregoing description relates to an exemplary embodiment of the present disclosure where the adhesive layer 20 has a planar shape larger than that of the electric part 15 is used and the adhesive layer 20 is positioned over the entire rear face of the electric part 15 and therearound. However, the present disclosure is not limited to the above-described embodiment.

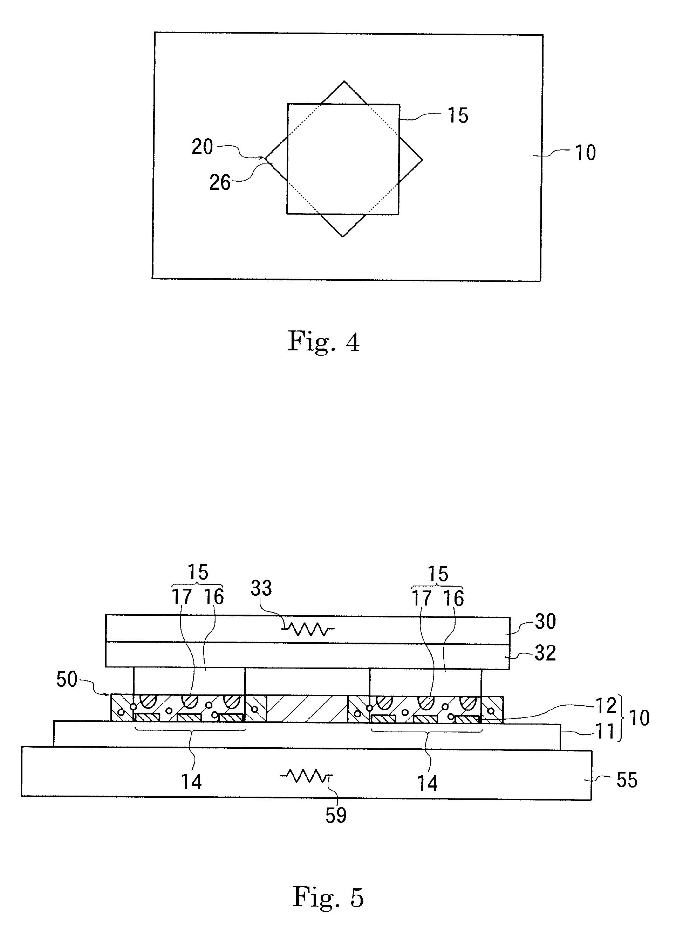

So long as the adhesive layer 20 is positioned at positions where the terminals 17 and the lands 12 are brought into contact with each other, there may be parts where the adhesive layer 20 is not positioned at a part of the rear face of the electric part 15, as shown in Fig. 4.

The protruding portion 26 of the adhesive layer does not need to surround the entire periphery of the electric part 15, and the former may be partially lack around the latter. If a direction in which the electric part 15 is likely to move is known in advance, depending upon the type of the electric part 15 and the pressing condition, the protruding portion 26 may be provided in a manner so as to avoid the movement.

However, if the direction in which the electric part 15 is misaligned cannot be anticipated, a part of the adhesive layer is preferably protruded outwardly from each of the sides forming from the planar-shape edge of the electric part 15, so that a force for moving the electric part 15 may be applied to any direction (Fig. 4). It is more preferred, as shown in Fig. 3(a), that the entire periphery of the electric part 15 is surrounded with the protruding portion 26.

The foregoing description relates to an aspect of the present disclosure where the adhesive layer 20 is constituted by a single small piece of the adhesive film. However, the present invention is not limited thereto. One adhesive layer 20 may constitute a plurality of pieces of the adhesive film.

Further, it is possible that after the adhesive layer 20 is formed on the face of the electric part 15 at which the terminals 17 are disposed with the adhesive layer protruding from the edge of the electric part 15, that face of the electric part 15 on which the adhesive layer 20 is formed is pushed against the substrate 10, and thus the adhesive layer 20 is positioned between the substrate 10 and the electric part 15.

In addition, the adhesive layer 20 is not limited to a film. The adhesive layer may also be formed by coating a paste material upon the mounting areas 14 of the substrate 10. In this embodiment, the adhesive layer 20 may be pasty, or the adhesive layer may be solidified by evaporating off a solvent in the adhesive prior to the second temporarily fixing step following the coating of the adhesive.

The foregoing description relates to an aspect of the present disclosure where one adhesive layer 20 is formed for one mounting area 14. However, the present disclosure is not limited thereto. As shown in Fig. 5, an adhesive layer 50 having a large area may be formed over a plurality of mounting areas 14.

When a plurality of electric parts 15 are to be mounted on the same substrate 10, each of the electric parts 15 may be pressed and mechanically connected one by one by means of the pressing head 30, or as shown in Fig. 5, the plurality of electric parts 15 may be pressed and mechanically connected at a time by means of a single pressing head 30.

The foregoing description relates to an aspect of the present disclosure where the heating means is provided in the pressing head 30. However, the present disclosure is not limited thereto. As shown in Fig. 5, heating means 59 may be provided in a pressing table 55, or heating means 33, 59 may be provided in both the pressing table 55 and the pressing head 30.

The type of the substrate 10 is not particularly limited, and a rigid substrate, a flexible substrate, or other types of substrates may be used. Further, the mounting method in this application can also be used for connecting the electric part 15 with another electric part, in addition to connecting between the substrate 10 and the electric part 15. The type of the electric part 15 is also not particularly limited, and various elements such as a semiconductor element (a bare chip, a package IC), a resistance element, etc. can be used.

When the contacting portion 32 of the pressing head 30 is made of an elastic material, a plurality of electric parts 15 can be pressed by the single pressing head 30 at a time, even if the heights of the electric parts 15 are different.

The contacting portion 32 of the pressing head 30 may be made of either the elastic material, such as an elastomer or a rubber, or a hard material such as a metal. The misalignment of the electric parts 15 is more likely to occur in cases where the contacting portion 32 is made of an elastic material as compared with cases where the contacting portion 32 is made of a hard material. Thus, the present application is particularly effective for embodiments where the contacting portion 32 is made of a hard material.

When the adhesive layer 20a is heated with the heating means 59 provided in the pressing table 55, the pressing tables may be exchanged among the heating step and the first and second temporarily fixing steps. Further, when the electric part 15 is to be pressed with the pressing head 30, it may be that the substrate 10 on which the electric part 15 is placed is arranged inside a furnace heated at a high temperature, and the electric part 15 is pressed inside the furnace.

The radiation-curable resin is not particularly limited, so long as it is cured with radiation rays having a predetermined wavelength. For example, the resin may be a material having a double bond or double bonds, such as (metha)acrylic double bond(s), within a molecule, and more specifically, the radiation-curable resin may be made of (metha) acrylate monomers or (metha) acrylate oligomers such as 1, 4-butanediol diacrylate, neopentyl glycol diacrylate, trimethylol propane triacrylate, tetramethylol methane triacrylate, tetramethylol methane tetraacrylate, pentaerythritol triacrylate, pentaerythritol tetraacrylate, hydrogenated bisphenol A ethylene oxide adducts diacrylates, trimethylolpropane trimethacrylate, etc., urethane acrylate oligomers, epoxy acrylates, oligoester acrylates, etc., allyl compounds such as triallyl isocyanurates, triallyl isocyanurates, etc., polymers (oligomers) in which a (metha)acrylate group is introduced into a side chain inside a molecule and which are each obtained by reacting a polymer having a reactive functional group such as a carboxylic acid group, a hydroxyl group in a side chain of the polymer with a monomers(oligomers) having a double bond in a molecule and a functional group in a polymer side chain, such as glycidyl methacrylate and methacryloyloxy ethylisocyanate.

Any one of these radiation-curable resins as described above may be used singly, or two or more types may be used in a mixture, or a photopolymerization initiator is preferably added into the binder 21 so as to increase the sensitivity of the radiation-curable resin.

The wavelength range in which the radiation-curable resin is polymerized is not particularly limited. However, if the resin curable in the visible light range is used, special illuminations need to be used during delivery and storage of the adhesive layer 20 and in the step of producing the electric device 1. Therefore, radiation-curable resins curable in the ultraviolet range are preferred.

Although the thermosetting resin is not particularly limited, the thermosetting resin is an epoxy resin having an epoxy group within a molecule, for example. More specifically, the thermosetting resin may be made of epoxy resins having glycidyl ether skeletons, such as a bisphenol A-type epoxy resin, a bisphenol F-type epoxy resin, a phenol novolac-type epoxy resin or the like; alicyclic epoxy resins having epoxy groups in cyclic structures; glycidyl ester-type epoxy resins derived from mono- or polyvalent carboxylic acids; epoxy resins having glycidyl amine groups and derived from primary or secondary amine compounds and epichlorohydrin; epoxy resins having triazine skeletons within molecules; polybutadiene-modified epoxy resins; materials having epoxy groups in rubbery materials, such as NBR-modified epoxy resins; acryl resins having glycidyl groups such as glycidyl methacrylate, glycidyl acrylate or the like in the (metha)acryl resins.

Any one of these thermosetting resins as described above may be used singly, or two or more kinds thereof may be used in a mixed state. Further, a curing agent for the thermosetting resin may be incorporated into the binder 21.

As described above, when the thermoplastic resin is incorporated into the binder 21, the adherence properties of the adhesive layer 20 are enhanced at the time of the first temporary fixing. Although the thermoplastic resin is not particularly limited, either a phenoxy resin, an acrylic rubber or the like can be used, for example. One type of the thermoplastic reins may be singly incorporated into the adhesive, or two or more kinds thereof may be incorporated into the adhesive in a mixed state.

The radiation rays 29 are not particularly limited, so long as they are of such a wavelength so as not to pass through the electric part 15. For example, when the electric part 15 is a silicon chip (bare chip), radiation rays having a wavelength which passes through silicon like infrared rays or X rays cannot be used. Radiation rays having a wavelength which does not allow them to pass through silicon like visible light or ultraviolet rays can be used.

Further, when the electric part 15 is constituted by a package IC in which a bare chip is packaged with a ceramic or an epoxy resin, radiation rays having such a wavelength that does not allow them to pass through the ceramic or epoxy resin such as the visible light or ultraviolet rays can be used.

Furthermore, if the electric part 15 is transparent with respect to a wide wavelength region, only the protruding portion 26 may be selectively irradiated with the radiation rays 29 by covering the electric part 15 with a mask or by using laser beams.

### [Example]

### <Example>

An adhesive in Example was prepared by mixing 5 g of trimethylolpropane triacrylate as a radiation-curable resin, 0.1 g of a photopolymerization initiator, sold under the name "IRGACURE 184", manufactured by Nihon Chiba-Geigy Kabushiki Kaisha, 20 g of an epoxy resin as a thermosetting resin (sold under the name "EPICOAT 828", manufactured by Japan Epoxy Resins Co., Ltd.), 10 g of a phenoxy resin as a thermoplastic resin (sold under the name "YP 50" manufactured by Tohto Kasei Co., Ltd.), 40 g of a thermoplastic resin-curing agent (sold under the name "HX3941HP" manufactured by Asahi Kasei Chemicals Corporation) and 10 g of nickel particles as conductive particles (diameter: 5µm, spherical form). This adhesive was brown to gray-brown, and of a paste consistency at room temperature.

### <Comparative Example>

An adhesive as Comparative Example was prepared under the same condition as in the above Example, except that the radiation-curable resin and the photopolymerization initiator were removed from the composition of the adhesive in the above Example and the additive amount of the conductive particles was changed from 10 g to 8 g. That adhesive had a paste consistency at room temperature.

The evaluation tests described below were conducted by using the adhesives in Example and Comparative Example mentioned above.

### <Evaluation Tests>

An adhesive layer 20 was formed by coating a mounting area 14 of a substrate 10 with the adhesive in Example such that the adhesive was protruded from the periphery of an electric part 15 when the electric part 15 was placed thereon. A silicon chip (bare chip) was placed as the electric part 15 on the adhesive layer 20.

After ultraviolet rays, which were radiation rays not passing through silicon, were irradiated on the face of the substrate 10 on which the electric part 15 was placed (1000mJ/cm²), the substrate 10 having the electric part 15 placed thereon was pressed under heating by means of a pressing head 30 with a contacting portion 32 made of a rubber. With respect to the electric devices 1 obtained, misaligned amounts of the electric parts 15 were measured with an X-ray observation device (Number of tests: 50).

During the tests, the electric parts 15 had a rectangular planar shape and the misaligned amounts were measured with respect to a direction (X-axis direction) in which mutually parallel two sides of the four sides of the electric part 15 extended and a direction (Y-axis direction) in which the other mutually parallel two sides extended.

Measurement results of the misaligned amounts are shown in the following Table 1.

**Table 1**

| Tab. 1: Result of Evaluation Test | | | |
|---|---|---|---|
| | Second temporarily fixing | Misaligned amount | |
| | | X-axis | Y-axis |
| Comparative Example | Thermal setting Thermal setting | 25 µm | 22 µm |
| Example | Radiation-ray curing | 10 µm | 9 µm |

It is clear from the results shown above in Table 1 that the misaligned amounts were small when the electric part 15 was mechanically connected by using the adhesive in the above Example after the radiation-curable resin in the protruding portion 26 was polymerized by irradiating radiation rays.

On the other hand, in the above Comparative Example, the electric part was mechanically connected by using the adhesive after the adhesive was half cured by heating, rather than by irradiation with the radiation rays, and at such a low temperature that the thermosetting resin was not completely cured. Consequently, as shown in the section of Comparative Example in Table 1, the misaligned amounts were greater in both the X-axis direction and the Y-axis direction.

It was confirmed from the above results that the misaligned amounts of the electric part 15 were small when that portion of the adhesive layer which protruded from the periphery of the electric part 15 was cured by the irradiation of the radiation rays.

## Claims

1. An electric part-mounting method comprising:
providing an adhesive layer containing a thermosetting resin and a radiation-curable resin,
arranging the adhesive layer, a substrate and an electric part in such a manner that the adhesive layer is positioned between the substrate and the electric part and a portion of the adhesive layer protrudes outwardly from an edge of the electric part,
irradiating radiation rays upon the protruding portion of the adhesive layer,
thereafter applying a pressing force between the electric part and the substrate, while the adhesive layer is heated, and mechanically connecting the electric part to the substrate.

2. The mounting method according to claim 1,
wherein the radiation rays comprise radiation rays having such a wavelength that does not allow them to pass through the electric part are used,
the radiation rays are irradiated from a face of the substrate on which the electric part is disposed, and
the radiation rays are irradiated to the electric part as well as to the protruding portion.

3. The mounting method according to claim 1,
wherein the adhesive layer is provided with a planar shape that is greater than that of the electric part being used, and
the edge of the electric part is surrounded by the protruding portion, when the adhesive layer is positioned between the substrate and the electric part.

4. An electric part-mounted substrate having an electric part that is temporarily fixed with a layer of an adhesive,
wherein the adhesive layer contains a radiation-curable resin and a thermosetting resin,
a portion of the adhesive layer is positioned between a substrate and the electric part, other portion of the adhesive layer protrudes outwardly from an edge of the electric part, and
the other portion of the adhesive layer protruding outwardly from the edge of the electric part having a photopolymer in which the radiation-curable resin is polymerized by irradiation with radiation rays.

5. An electric device having an electric part fixed to a substrate with a layer of an adhesive,
wherein the adhesive layer contains a radiation-curable resin and a thermosetting resin, a portion of the adhesive layer is positioned between the electric part and the substrate, other portion of the adhesive layer protrudes outwardly from an edge of the electric part,
the other portion of the adhesive layer protruding outwardly from the edge of the electric part having a photopolymer in which the radiation-curable resin is polymerized by irradiation with radiation rays, and
the portion of the adhesive layer between the electric part and the substrate having a thermally polymerized material in which the thermosetting resin is cured by heating.
